# EUROPÄISCHE PATENTSCHRIFT

(11) **EP 1 525 090 B1**
(45) Veröffentlichungstag und Bekanntmachung des Hinweises auf die Patenterteilung: **30.09.2015**
(21) Anmeldenummer: 03783950.3
(22) Anmeldetag: 04.08.2003
(51) Int. Cl.: B32B 18/00, C04B 35/638, H01G 4/12, H01L 21/48, H05K 1/16, H05K 1/03, H05K 3/46

(54) **VERFAHREN ZUR HERSTELLUNG EINES KERAMISCHEN SUBSTRATS**
METHOD FOR PRODUCING A CERAMIC SUBSTRATE
PROCEDE DE PRODUCTION D'UN SUBSTRAT CERAMIQUE

(30) Priorität: 02.08.2002 DE 10235452
(43) Veröffentlichungstag der Anmeldung: 27.04.2005
(73) Patentinhaber: EPCOS AG, 81669 München (DE)
(72) Erfinder: ALTHOFF, Anke, 3423 St.-Andrä-Wördern (AT); GRABNER, Holger, A-7011 Zagersdorf (AT)
(74) Vertreter: Epping - Hermann - Fischer
(86) Internationale Anmeldenummer: PCT/DE2003/002611
(87) Internationale Veröffentlichungsnummer: WO 2004/014647

(56) Entgegenhaltungen:
- EP-A- 0 487 196
- DE-C- 19 945 014
- FR-A- 2 533 313
- US-A- 4 627 160
- US-A- 5 252 519
- PATENT ABSTRACTS OF JAPAN vol. 2000, no. 13, 5. Februar 2001 (2001-02-05) & JP 2000 302558 A (MATSUSHITA ELECTRIC IND CO LTD), 31. Oktober 2000 (2000-10-31)

## Beschreibung

Die Erfindung betrifft ein Verfahren zur Herstellung eines keramischen Substrats mit einem Stapel von übereinanderliegenden Schichten.

Die Schichten des Stapels enthalten jeweils ein ungesintertes Keramikmaterial und Bindemittel und bilden zusammen einen Grundkörper, der entbindert und gesintert wird.

Es ist z. B. ein Verfahren bekannt, bei dem das Entkohlen des Grundkörpers in einem Kammerofen durchgeführt wird, welcher über eine längere Zeit auf eine für das Entkohlen geeignete Temperatur geheizt wird. Anschließend wird der auf die Raumtemperatur abgekühlte Grundkörper dem Kammerofen entnommen und zusammen mit anderen bereits entkohlten Grundkörper mit einem Förderband einem Förderband-fähigen Sinterofen zugeführt. Das Sintern dauert nicht so lange wie das Entkohlen, weswegen die Verwendung eines kontinuierlichen Prozesses hier in Betracht kommt.

Das bekannte Verfahren hat den Nachteil, daß es zur Herstellung von Vielschichtsubstraten aus verschiedenen Keramikmaterialien mit unterschiedlichen Dielektrizitätskonstanten und in der Regel unterschiedlichen thermischen Ausdehnungskoeffizienten, bei denen Schichten mit Durchkontaktierungen versehen sind, nicht geeignet ist. Es wurde festgestellt, daß bei der Herstellung solcher Vielschichtsubstrate häufig Risse zwischen den Durchkontaktierungen, die üblicherweise aus einer metallhaltigen Paste gefertigt sind, und der die Umgebung der Durchführung bildenden keramischen Schicht auftreten.

Aus den Druckschriften US 4,627,160 A, US 5,252,519 A, JP 2000-302558 A, FR 2533313 A, EP 0487196 A und DE 19945014 C sind Verfahren zur Herstellung keramischer Substrate bekannt.

Es ist daher Aufgabe der vorliegenden Erfindung, ein Verfahren zur Herstellung eines keramischen Vielschichtsubstrats anzugeben, bei dem die Gefahr der Rißbildung vermindert ist. Diese Aufgabe wird gelöst durch ein Verfahren nach Patentanspruch 1. Vorteilhafte Ausgestaltungen des Verfahrens sind den weiteren Patentansprüchen zu entnehmen.

Es wird ein Verfahren zur Herstellung eines keramischen Substrats angegeben, bei dem in einem ersten Schritt ein Grundkörper bereitgestellt wird. Der Grundkörper weist einen Stapel von übereinanderliegenden Schichten auf. Die übereinanderliegenden Schichten bestehen jeweils aus einem ungesinterten Keramikmaterial, welches ferner noch ein Bindemittel enthält. Der Grundkörper weist elektrisch leitende vertikale Durchführungen auf, die jeweils durch zumindest eine der Schichten hindurch gehen. In einem weiteren Schritt werden die Schichten in inerter Atmosphäre (z. B. in einer Stickstoff enthaltenden Atmosphäre) entbindert, wobei während des Entbinderns eine Mindesttemperatur gehalten wird. Im darauffolgenden Schritt wird der Grundkörper gesintert, wobei das Sintern bei einer Temperatur stattfindet, die größer als die Mindesttemperatur der Entbinderung ist. Die Mindesttemperatur der Entbinderung ist von der Zusammensetzung des zu entbindernden Materials abhängig. Während der gesamten Dauer der beiden letztgenannten Verfahrensschritte wird die Temperatur T des Grundkörpers so gehalten, daß sie die Mindesttemperatur T_{E1} der Entbinderung nicht unterschreitet.

Sowohl Entbindern als auch Sintern werden erfindungsgemäß in ein und demselben Ofen durchgeführt. Dies verhindert das Abkühlen des keramischen Grundkörpers auf Raumtemperatur. Ferner wird das Verfahren dadurch vereinfacht, da ein Wechsel des Ofens vermieden wird.

Das Verfahren hat den Vorteil, daß ein Abkühlen des Grundkörpers auf Raumtemperatur zwischen dem Entbindern und dem Sintern vermieden wird. Das Abkühlen des Grundkörpers auf Raumtemperatur zwischen dem Entbindern und dem Sintern birgt nämlich die Gefahr in sich, daß aufgrund der unterschiedlichen thermischen Ausdehnungskoeffizienten der elektrisch leitenden Durchführung und der umgebenden Schicht Risse entstehen. Aufgrund des Verfahrens wird die Abkühlung auf Raumtemperatur vermieden, wodurch auch die Gefahr der Entstehung von Rissen vermindert werden kann. Der Grundkörper wird erst nach dem Sintern, also in dem Stadium abgekühlt, in dem die Keramikmaterialien bereits eine ausreichende Festigkeit haben, um so die Gefahr der Entstehung von Rissen wirksam zu vermindern.

Unter Entbindern soll ein Prozeß verstanden werden, der geeignet ist, die organischen Bestandteile, insbesondere Lösungs- und Bindemittel, aus den Schichten zu verflüchtigen. Die Atmosphäre im Ofen wird während des Entbinderns umgestellt, um z. B. die Geschwindigkeit des Oxidierens der organischen Komponenten zu steuern. Eine zusätzliche Möglichkeit, die Geschwindigkeit des Oxidierens zu steuern, ist eine entsprechende Einstellung des Temperaturprogramms des Ofens, wobei die Richtung und Rate der Temperaturänderung zweckmäßig variiert werden. Z. B. kann die Temperatur in einigen Zeitbereichen konstant gehalten oder abgesenkt werden, wobei jedoch die momentane Temperatur zu jeder Zeit oberhalb der Mindesttemperatur des Entbinderns liegt.

Die Entbinderung wird erfindungsgemäß in einem Temperaturbereich T_{E1} - T_{E3} (T_{E1} < T_{E3}) durchgeführt, wobei die Temperatur in einer Variante der Erfindung während der Entbinderung im Wesentlichen monoton von T_{E1} auf T_{E3} erhöht werden kann.

Die Temperatur wird zunächst monoton von T_{E1} auf T_{E2} (T_{E1} < T_{E2} < T_{E3}) erhöht. Dieser Schritt erfolgt in inerter Atmosphäre, wobei unerwünschtes Oxidieren der Lösungs- und Bindemittel absichtlich (vorübergehend) verringert bzw. verhindert werden kann.

Anschließend wird die Atmosphäre im Ofen auf Luftatmosphäre umgestellt. Beim Umstellen der Ofenatmosphäre bei vergleichsweise hohen Temperaturen > T_{E2} besteht die Gefahr, daß das Oxidieren der organischen Komponenten zu schnell erfolgt und das dabei entstehende Kohlenstoffdioxid aus den Schichten explosionsartig heraustritt. Um das zu schnelle Heraustreten von Kohlenstoffdioxid aus den Schichten zu unterbinden, wird gleichzeitig mit der Umstellung der Atmosphäre die Temperatur T des Grundkörpers auf den Wert von T_{E1} ≤ T_{E1'} < T_{E2} (vorzugsweise annähernd bis T_{E1}) abgesenkt. Anschließend wird die Temperatur monoton bis zur Endtemperatur T_{E3} des Entbinderns erhöht.

Anschließend erfolgt eine weitere Erhöhung der Temperatur auf zumindest den Wert, der zum Sintern aller Schichten erforderlich ist. Erst nach dem Sintern wird der Grundkörper bzw. das Vielschichtsubstrat im Ofen auf Raumtemperatur abgekühlt und dem Ofen entnommen.

Das Abkühlen des Grundkörpers auf die Raumtemperatur erfolgt also erst in einem Stadium, in dem die Festigkeit der Keramikschichten bereits ausreichend ist, um die Gefahr der Entstehung von Rissen zu vermindern.

Zwischen den Schichten sind vorzugsweise strukturierte Metallisierungsebenen vorgesehen, welche wie auch die vertikalen elektrischen Durchführungen mit einer metallhaltigen Paste erzeugt werden können.

Vorteilhafterweise kann als Stapel von übereinanderliegenden Schichten ein Stapel verwendet werden, bei dem die Keramikmaterial enthaltenden Schichten jeweils Durchbrüche aufweisen, welche mit einer metallhaltigen Paste gefüllt sind. Dies hat den Vorteil, daß die elektrisch leitenden Verbindungen zwischen übereinander angeordneten Metallebenen auf einfache Art und Weise hergestellt werden können.

Die ungesintertes Keramikmaterial enthaltenden Schichten, welche üblicherweise auch als Grünfolien bezeichnet werden, können bereits vor der Bildung des Stapels mit Durchbrüchen versehen werden. Dies kann beispielsweise mittels Stanzen geschehen. Nach dem Stanzen werden die Durchbrüche mit einer metallhaltigen Paste gefüllt. Erst danach werden die Grünfolien übereinandergestapelt und durch Laminieren der Grundkörper hergestellt.

Vorteilhafterweise kann als metallhaltige Paste eine Paste verwendet werden, die Edelmetalle wie Silber und Palladium enthält.

Desweiteren ist es vorteilhaft, wenn sich in dem Stapel die Materialien von übereinanderliegenden Schichten unterscheiden und im Stapel so wenigstens zwei voneinander verschiedene Keramikmaterialien enthalten sind. Beispielsweise kommt es in Betracht, für eine im Innern des Stapels liegende Grünfolie ein Keramikmaterial zu verwenden, welches eine Dielektrizitätskonstante von etwa ∈ = 20 aufweist. Dadurch gelingt die Herstellung von keramischen Substraten, die Kondensatoren einer hohen Kapazität enthalten. Desweiteren ist es vorteilhaft, die unterste und die oberste Schicht des Stapels von übereinanderliegenden Schichten mittels eines Keramikmaterials herzustellen, das eine niedrigere Dielektrizitätskonstante von z. B. ∈ = 8 aufweist.

Desweiteren ist es vorteilhaft, die Materialien gemäß der folgenden Regel auszuwählen:
Ein erstes im Grundkörper enthaltenes Keramikmaterial beginnt bei einer Temperatur T_{S1} zu sintern. Ein zweites im Grundkörper enthaltenes Keramikmaterial beginnt bei einer Temperatur T_{S3} zu sintern. Ferner beginnt die im Grundkörper enthaltene metallhaltige Paste bei einer Temperatur T_{S2} zu sintern. Ferner gilt: T_{S1} < T_{S2} < T_{S3}. Um einen dicht gesinterten Grundkörper zu erhalten, wird vorzugsweise bei einer Temperatur gesintert, welche die Sintertemperatur T_{S3} übersteigt.

Für die Dielektrizitätskonstante ∈₁ desjenigen Keramikmaterials, das die kleinere Dielektrizitätskonstante aufweist, kann vorteilhafterweise gelten: 7 ≤ ∈1 < 8,5.

Ferner kann für die Dielektrizitätskonstante ∈₂ desjenigen Keramikmaterials, das die größere Dielektrizitätskonstante aufweist, gelten: 18 ≤ ∈₂ ≤ 22.

Auf der obersten Schicht, unter der untersten Schicht und zwischen zwei übereinander liegenden Schichten kann je eine strukturierte Metallisierungsebene vorgesehen sein, die aus der metallhaltigen Paste gebildet wird. Die Durchführungen stellen vertikale elektrische Verbindugen zwischen den Metallisierungsebenen dar.

Im folgenden wird die Erfindung anhand eines Ausführungsbeispieles und den dazugehörigen Figuren näher erläutert.
- Figur 1: zeigt beispielhaft den Temperaturverlauf während der Durchführung des erfindungsgemäßen Verfahrens in einem Diagramm, bei dem die Temperatur über der Zeit aufgetragen ist.
- Figur 2: zeigt beispielhaft ein mit erfindungsgemäßen Verfahren hergestelltes Substrat in einem schematischen Querschnitt.

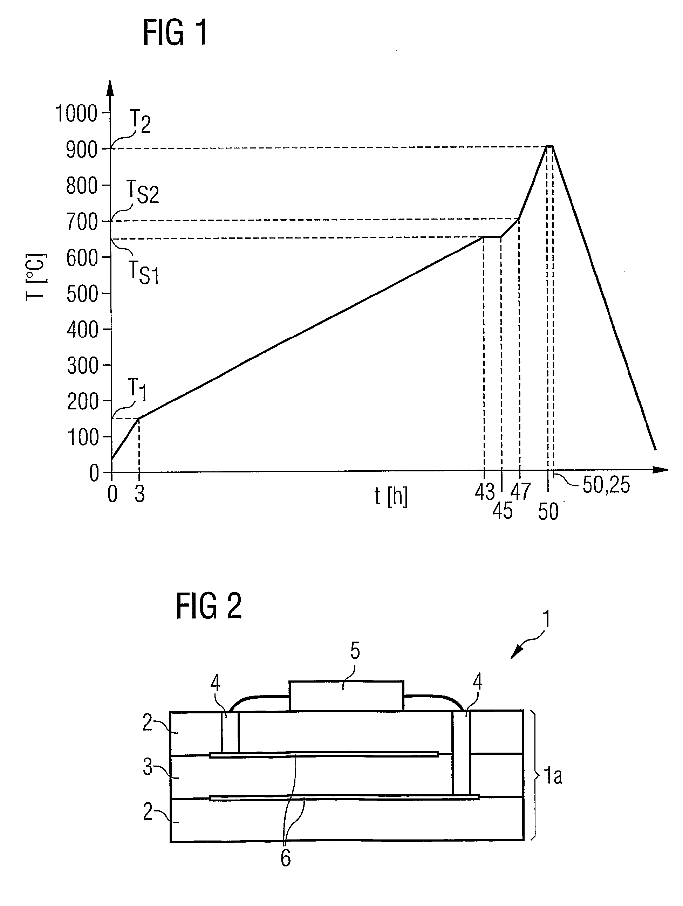

Figur 1 zeigt ein beispielhaftes Temperaturprofil für die Anwendung des erfindungsgemäßen Verfahrens zur Herstellung eines keramischen Substrats. Ein oder auch mehrere Grundkörper werden beginnend bei Raumtemperatur während einer Dauer von 3 Stunden auf eine Temperatur T_{E1} (Beginn der Entbinderung) aufgeheizt. Diese Temperatur T_{E1} beträgt in dem Beispiel aus Figur 1 T_{E1} = 200° C. Dies ist die Temperatur, die hier während des Entbinderns nicht unterschritten werden sollte. Die Erhöhung der Temperatur bis T_{E1} kann in Luft-Atmosphäre oder alternativ in inerter Atmosphäre erfolgen.

Ab dieser Temperatur beginnt nun ein großer Teil der organischen Bestandteile zu entweichen. Deshalb wird die Temperatur in inerter Atmosphäre und dabei gleichmäßig und langsam (z. B. ca. 13 Stunden) auf einen Wert T_{E2} erhöht. Im weiteren Verlauf des Verfahrens wird der Ofen auf Luft-Atmosphäre umgestellt und dabei die Temperatur zunächst wieder auf den Wert T_{E1} ≤ T < T_{E2} abgesenkt. Ohne eine derartige Temperaturabsenkung kann es zu explosionsartigen Verpuffungen kommen, die zur Beschädigung bis zur Zerstörung des keramischen Grundkörpers führen können.

Nach der Umstellung des Ofens auf die Luft-Atmosphäre wird der Entkohlungsprozeß fortgesetzt. Der Temperatur des Grundkörpers wird nun auf eine Temperatur T_{E3} angehoben, die vorzugsweise 450°C beträgt und für eine Dauer von rund 1 Stunde konstant gehalten wird. Nun entweichen auch die letzten organischen Bestandteile des Grundkörpers. Anschließend ist das Entkohlen abgeschlossen. Der keramische Grundkörper wird daraufhin rampenförmig auf die Sintertemperatur T_{S1} aufgeheizt, bei der die Schichten 2 aus einem ersten Keramikmaterial zu sintern beginnen.

Für das beispielhafte Temperaturprofil aus Figur 1 wird ein keramisches Substrat gemäß Figur 2 betrachtet. Dieses keramische Substrat umfaßt einen Grundkörper 1, welcher einen Stapel 1a von übereinanderliegenden Schichten 2, 3 enthält. Die übereinanderliegenden Schichten 2, 3 enthalten ein ungesintertes Keramikmaterial, welches seinerseits zusätzliche organische Bestandteile wie Lösungsmittel und Bindemittel enthält. Dabei sind die Schichten 2 vorzugsweise so ausgeführt, daß sie nach dem Sintern eine Dielektrizitätskonstante ε1 von ca. 8 aufweisen. Zwischen den beiden Schichten 2 befindet sich noch eine weitere Schicht 3, die aus einem zweiten Keramikmaterial besteht (oder zumidest eine Teilschicht aus dem zweiten Keramikmaterial umfaßt). Das zweite Keramikmaterial ist ein Keramikmaterial (vorzugsweise ein sogenanntes K20-Material) mit einer Dielektrizitätskonstante ∈₂, die von ∈₁ unterschiedlich ist. Das K20-Material ist ein Keramikmaterial, welches eine Dielektrizitätskonstante ∈₂ von etwa 20 aufweist. Ferner sind in den Schichten 2, 3 vertikale Durchbrüche ausgebildet, die mit einer metallhaltigen Paste gefüllt sind und so elektrisch leitende Durchführungen 4 bilden. In den einzelnen Lagen der Schicht 3 sind Innenelektroden 6 so angeordnet, dass ein Kondensator gebildet wird. Der Kondensator ist mit einem elektrischen Bauelement 5 auf der Oberseite des Grundkörpers 1 elektrisch leitend verbunden.

Die Sintertemperaturen der Materialien in den Schichten 2 und 3 beziehungsweise in der elektrisch leitenden Durchführung 4 sind so gewählt, daß für die Sintertemperatur T_{S1} des Keramikmaterials der Schicht 2, für die Sintertemperatur T_{S3} des Keramikmaterials der Schicht 3 sowie für die Sintertemperatur T_{S2} der metallhaltigen Paste gilt: T_{S1} < T_{S2} < T_{S3}. Gemäß Figur 1 gilt für die Temperaturen:
T_{S1} = 625° C
T_{S3} = 700° C

Daraus geht hervor, daß nach der über die lange Dauer von 40 Stunden hochgefahrenen Rampe eine Temperatur von 625° C erreicht wird, bei der das erste Keramikmaterial zu sintern beginnt. Die Temperatur wird ca. 2 Stunden konstant gehalten und anschließend schnell auf den Wert T_{S} ≥ T_{S3}, z. B. T_{S} = 900° C erhöht. Somit wird eine Temperatur erreicht, bei der die Schichten 2, 3 des keramischen Grundkörpers dicht sintern. Gleichzeitig beginnen nämlich während der Temperaturerhöhung von T_{S1} auf T_{S} auch die Schicht 3 aus dem zweiten Keramikmaterial mit der Sintertemperatur T_{S3} sowie die metallische Durchführung und die Innenmetallisierung zu sintern. Diese Temperatur wird nun für 0,25 Stunden gehalten, um einen dicht gesinterten keramischen Grundkörper zu erhalten.

Erst nachdem alle Schichten und Materialien des Grundkörpers gesintert sind, wird gemäß Figur 1 die Temperatur langsam auf Raumtemperatur heruntergefahren.

Zumindest eine der Schichten aus dem ersten Keramikmaterial kann mit zumindest einer der Schichten aus dem zweiten Keramikmaterial einen Schichtverbund bilden, wobei vorzugsweise mehrere solche Schichtverbunde gebildet werden und wobei die strukturierten Metallisierungsebenen jeweils zwischen den Schichtverbunden vorgesehen werden.

Die vorliegende Erfindung beschränkt sich nicht auf die Herstellung von Substraten, die K8- beziehungsweise K20-Materialien enthalten, sondern ist auf jede Art von keramischen Substraten, die Durchkontaktierungen beziehungsweise elektrisch leitende Durchführungen enthalten, anwendbar.

### Bezugszeichenliste

- 1: Grundkörper
- 1a: Stapel
- 2: Schicht
- 3: Schicht
- 4: Durchführung
- 5: elektrisches Bauelement
- 6: Innenelektrode
- T_{E1}: Mindesttemperatur der Entbinderung
- T_{E2}: max. Temperatur der Entbinderung in inerter Atmosphäre
- TE3: Maximale Temp. der Entbinderung
- T_{S1}: Sinterbeginn der ersten Keramikschicht
- T_{S2}: Sinterbeginn der metallhaltigen Paste
- T_{S3}: Sinterbeginn der ersten Keramikschicht
- Ts: Sintertemperatur des Grundkörpers
- T: Temperatur
- t: Zeit

## Patentansprüche

1. Verfahren zur Herstellung eines keramischen Substrats mit folgenden Schritten:
a) Bereitstellen eines Grundkörpers (1), umfassend einen Stapel (la) von übereinanderliegenden Schichten (2, 3), die jeweils ein ungesintertes Keramikmaterial und ein Bindemittel enthalten, wobei in den Schichten (2, 3) jeweils elektrisch leitende Durchführungen (4) vorgesehen sind,
b) Entbindern der Schichten (2, 3) in einem Temperaturintervall T_{E1} - T_{E3}, wobei T_{E}, die Mindesttemperatur der Entbinderung und T_{E3} > T_{E1} ist, wobei zunächst ein erster Teil des Entbinderns in inerter Atmosphäre im Temperaturintervall T_{E1} - T_{E2} bei monotoner Temperaturerhöhung durchgeführt wird,
wobei T_{E1} < T_{E2} < T_{E3} ist, und anschließend die Temperatur T auf den Wert von T_{E1} mit T_{E1} ≤ T_{E1} < T_{E2} abgesenkt wird, wobei die Atmosphäre im Ofen gleichzeitig mit der Absenkung der Temperatur T auf den Wert von T_{E1} ≤ T_{E1} < T_{E2} auf Luftatmosphäre umgestellt wird, wobei anschließend an Schritt b) die Temperatur T auf den Wert T_{E3} monoton erhöht wird,
c) Dicht Sintern der Schichten (2, 3) bei einer Temperatur Tₛ ≥ T_{E3}, wobei die Verfahrensschritte b) und c) in ein und demselben Ofen durchgeführt werden,
wobei die Temperatur T des Grundkörpers (1) während der gesamten Dauer vom Beginn des Verfahrensschritts b) bis zum Ende des Verfahrensschritts c) so gehalten wird, daß sie die Mindesttemperatur T_{E1} der Entbinderung nicht unterschreitet

2. Verfahren nach Anspruch 1,
bei dem vor Verfahrensschritt a) in den übereinanderliegenden Schichten (2, 3) Durchbrüche ausgebildet und jeweils mit einer metallhaltigen Paste gefüllt werden.

3. Verfahren nach Anspruch 2,
wobei eine metallhaltige Paste verwendet wird, die Silber oder Silber-Palladium enthält.

4. Verfahren nach einem der Ansprüche 1 bis 3,
wobei wenigstens zwei der übereinander liegenden Schichten (2, 3) aus verschiedenen Keramikmaterialien bestehen.

5. Verfahren nach einem der Ansprüche 2 bis 4,
bei dem eine erste Schicht aus einem ersten Keramikmaterial und die darüber liegende zweite Schicht (2, 3) aus einem zweiten Keramikmaterial bereitgestellt werden, wobei das erste Keramikmaterial bei einer Temperatur T_{S1} und das zweite Keramikmaterial bei einer Temperatur T_{S3} zu sintern beginnt, wobei die metallhaltige Paste bei einer Temperatur T_{S2} zu sintern beginnt,
wobei gilt: T_{S1} < T_{S2} < T_{S3}.

6. Verfahren nach Anspruch 5,
wobei das erste Keramikmaterial so ausgewählt wird, daß es im gesinterten Zustand eine Dielektrizitätskonstante ε₁ aufweist, wobei gilt: 7 ≤ ε₁ ≤ 8,5 und
wobei das zweite Keramikmaterial so ausgewählt wird, daß es im gesinterten Zustand eine Dielektrizitätskonstante ε₂ aufweist, wobei gilt: 18 ≤ ε₂ ≤ 22.

7. Verfahren nach einem der Ansprüche 2 bis 6,
bei dem zwischen den übereinander liegenden Schichten (2, 3) strukturierte Metallisierungsebenen vorgesehen werden, die aus der metallhaltigen Paste gebildet werden.

8. Verfahren nach Anspruch 6,
bei dem zumindest eine der Schichten aus dem ersten Keramikmaterial mit zumindest einer der Schichten aus dem zweiten Keramikmaterial einen Schichtverbund bildet,
wobei mehrere solche Schichtverbunde gebildet werden,
wobei die strukturierten Metallisierungsebenen jeweils zwischen den Schichtverbunden ausgebildet werden.

9. Verfahren nach einem der Ansprüche 1 bis 8,
bei dem die Verfahrensschritte b) und c) in inerter Atmosphäre durchgeführt werden.

## Claims

1. Process for producing a ceramic substrate, which comprises the following steps:
a) provision of a base body (1) comprising a stack (1a) of superposed layers (2, 3) which each contain an unsintered ceramic material and a binder, where electrically conductive lead-throughs (4) are in each case provided in the layers (2, 3),
b) removal of binder from the layers (2, 3) in a temperature range T_{E1} - T_{E3}, where T_{E1} is the minimum temperature of the binder removal and T_{E3} > T_{E1}, where a first part of the binder removal is firstly carried out in an inert atmosphere in the temperature range T_{E1} - T_{E2} with a monotonic increase in temperature,
where T_{E1} < T_{E2} < T_{E3}, and the temperature T is subsequently lowered to the value of T_{E1}, where T_{E1} ≤ T_{E1'} ≤ T_{E2}, where the atmosphere in the furnace is changed over to an air atmosphere simultaneously with the lowering of the temperature T to the value of T_{E1} ≤ T_{E1'} ≤ T_{E2}, where the temperature T is increased monotonically to the value T_{E3} subsequent to step b),
c) sintering to high density of the layers (2, 3) at a temperature Tₛ ≥ T_{E3}, where the process steps b) and c) are carried out in one and the same furnace,
where the temperature T of the base body (1) during the entire time from the beginning of process step b) to the end of process step c) is maintained in such a way that it does not go below the minimum temperature T_{E1} of the binder removal.

2. Process according to Claim 1,
wherein openings are formed in the layers (2, 3) located on top of one another and are each filled with a metal-containing paste before process step a).

3. Process according to Claim 2,
wherein a metal-containing paste containing silver or silver-palladium is used.

4. Process according any of Claims 1 to 3,
wherein at least two of the layers (2, 3) located on top of one another consist of different ceramic materials.

5. Process according to any of Claims 2 to 4,
wherein a first layer composed of a first ceramic material and the second layer (2, 3) which is composed of a second ceramic material and is located on top of the first layer are provided, where the first ceramic material begins to sinter at a temperature T_{S1} and the second ceramic material begins to sinter at a temperature T_{S3}, where the metal-containing paste begins to sinter at a temperature T_{S2},
where: T_{S1} < T_{S2} < T_{S3}.

6. Process according to Claim 5,
wherein the first ceramic material is selected so that in the sintered state it has a dielectric constant ε₁, where: 7 ≤ ε₁ ≤ 8.5, and
the second ceramic material is selected so that in the sintered state it has a dielectric constant ε₂, where: 18 ≤ ε₂ ≤ 22.

7. Process according to any of Claims 2 to 6,
wherein structured metallisation planes formed from the metal-containing paste are provided between the superposed layers (2, 3).

8. Process according to Claim 6,
wherein at least one of the layers composed of the first ceramic material forms a layer composite with at least one of the layers composed of the second ceramic material,
where a plurality of such layer composites are formed and the structured metallisation planes are in each case formed between the layer composites.

9. Process according to any of Claims 1 to 8,
wherein the process steps b) and c) are carried out in an inert atmosphere.

## Revendications

1. Procédé de fabrication d'un substrat céramique comprenant les étapes suivantes :
a) la préparation d'un corps de base (1), comprenant une pile (la) de couches superposées (2, 3), qui contiennent chacune un matériau céramique non fritté et un liant, des passages électriquement conducteurs (4) étant prévus dans chacune des couches (2, 3),
b) le déliantage des couches (2, 3) dans un intervalle de température T_{E1}-T_{E3}, T_{E1} étant la température minimale du déliantage et T_{E3} > T_{E1}, une première partie du déliantage étant tout d'abord réalisée dans une atmosphère inerte dans l'intervalle de température T_{E1}-T_{E2} avec une augmentation monotone de la température, avec T_{E1} < T_{E2} < T_{E3}, puis la température T étant abaissée à la valeur T_{E1}' avec T_{E1} ≤ T_{E1}' < T_{E2}, l'atmosphère dans le four étant convertie en une atmosphère d'air simultanément avec la réduction de la température T à la valeur T_{E1} ≤ T_{E1}' < T_{E2}, la température T étant augmentée de manière monotone à la valeur T_{E3} après l'étape b),
c) le frittage étanche des couches (2, 3) à une température Tₛ ≥ T_{E3}, les étapes de procédé b) et c) étant réalisées dans un même four,
la température T du corps de base (1) étant maintenue pendant la durée totale depuis le début de l'étape de procédé b) jusqu' à la fin de l'étape de procédé c), de manière à ne pas passer en dessous de la température minimale T_{E1} du déliantage.

2. Procédé selon la revendication 1, dans lequel, avant l'étape de procédé a), des perforations sont formées dans les couches superposées (2, 3) et chacune remplies avec une pâte contenant un métal.

3. Procédé selon la revendication 2, dans lequel une pâte contenant un métal qui contient de l'argent ou de l'argent-palladium est utilisée.

4. Procédé selon l'une quelconque des revendications 1 à 3, dans lequel au moins deux des couches superposées (2, 3) sont constituées de différents matériaux céramiques.

5. Procédé selon l'une quelconque des revendications 2 à 4, dans lequel une première couche en un premier matériau céramique et la deuxième couche superposée (2, 3) en un deuxième matériau céramique sont préparées, le premier matériau céramique commençant à se fritter à une température T_{S1} et le deuxième matériau céramique à une température T_{S3}, la pâte contenant un métal commençant à se fritter à une température T_{S2},
avec : T_{S1} < T_{S2} < T_{S3}.

6. Procédé selon la revendication 5, dans lequel le premier matériau céramique est choisi de manière à présenter à l'état fritté une constante diélectrique ε₁ telle que : 7 ≤ ε₁ ≤ 8,5, et
le deuxième matériau céramique est choisi de manière à présenter à l'état fritté une constante diélectrique ε₂ telle que : 18 ≤ ε₂ ≤ 22.

7. Procédé selon l'une quelconque des revendications 2 à 6, dans lequel des plans de métallisation structurés formés par la pâte contenant un métal sont prévus entre les couches superposées (2, 3).

8. Procédé selon la revendication 6, dans lequel au moins une des couches en le premier matériau céramique forme un composite stratifié avec au moins une des couches en le deuxième matériau céramique, plusieurs de ces composites stratifiés étant formés, les plans de métallisation structurés étant formés entre chacun des composites stratifiés.

9. Procédé selon l'une quelconque des revendications 1 à 8, dans lequel les étapes de procédé b) et c) sont réalisées dans une atmosphère inerte.
